# EUROPÄISCHE PATENTSCHRIFT

(11) **EP 3 003 672 B1**
(45) Veröffentlichungstag und Bekanntmachung des Hinweises auf die Patenterteilung: **16.08.2017**
(21) Anmeldenummer: 14728951.6
(22) Anmeldetag: 06.06.2014
(51) Int. Cl.: H01L 23/00, H01L 51/00, H01L 31/02, H01L 33/56, H01L 31/0203, H01L 51/52, H01L 51/56, H01L 31/048, H01L 31/05, H01L 31/18, H01L 33/62, H05K 1/02, H05K 1/14, H05K 1/18, H05K 3/46

(54) **VERFAHREN ZUR HERSTELLUNG EINES OPTISCHEN MODULS**
METHOD FOR PRODUCING AN OPTICAL MODULE
PROCÉDÉ DE FABRICATION D'UN MODULE OPTIQUE

(30) Priorität: 07.06.2013 DE 102013210668
(43) Veröffentlichungstag der Anmeldung: 13.04.2016
(73) Patentinhaber: Würth Elektronik GmbH & Co. KG, 74676 Niedernhall (DE)
(72) Erfinder: KOSTELNIK, Jan, 74592 Kirchberg (DE); WOLF, Jürgen, 74635 Kupferzell (DE)
(74) Vertreter: Richardt Patentanwälte PartG mbB
(86) Internationale Anmeldenummer: PCT/EP2014/061788
(87) Internationale Veröffentlichungsnummer: WO 2014/195444

(56) Entgegenhaltungen:
- DE-A1-102007 004 304
- US-A1- 2009 250 106
- CHENG K ET AL: "Ink-Jet Printing, Self-Assembled Polyelectrolytes, and Electroless Plating: Low Cost Fabrication of Circuits on a Flexible Substrate at Room Temperature", MAKROMOLEKULARE CHEMIE, RAPID COMMUNICATIONS, HUTHIG UND WEPF VERLAG. BASEL, CH , Bd. 26, Nr. 4 21. Februar 2005 (2005-02-21), Seiten 247-264, XP002605918, DOI: 10.1002/MARC.200400462 Gefunden im Internet: URL:http://onlinelibrary.wiley.com/doi/10. 1002/marc.200400462/pdf [gefunden am 2010-10-19]

## Beschreibung

Die Erfindung betrifft ein Verfahren zur Herstellung eines optischen Moduls mit einem in einen Chip integrierten optischen Element, insbesondere einem lichtemittierenden optischen Element, wie zum Beispiel einer LED, EED, HCSELD, OLED oder PLED und/oder einem optischen Sensor.

Aus der DE 10 2007 007 847 A1 ist eine Licht aussendende Vorrichtung und ein Verfahren zu deren Herstellung bekannt. Zur Herstellung der Vorrichtung werden die Anoden- und Kathodenanschlüsse einer LED durch Drahtbonden elektrisch kontaktiert und es wird ein Vergussharz eingesetzt.

Aus der DE 10 2007 044 446 A1 ist ein flexibler Schaltkreis mit einem Array aus LEDs bekannt. Auch hier werden die LEDs durch Drahtbonding kontaktiert.

Aus der DE 199 53 160 B4 ist eine Elektrodenstruktur für LEDs bekannt, bei der die Elektroden für das Wire-Bonding in einem Randbereich angeordnet sein können.

Bei LEDs erfolgt die Abstrahlung des Lichts im Allgemeinen durch eine obere transparente Elektrode. Dies muss aber nicht zwangsläufig so sein:
Aus dem Stand der Technik sind an sich Edge-Emitting Laser Diodes (EELs) bekannt, beispielsweise aus US 5,105,430, bei denen das Licht seitlich abgestrahlt wird sowie auch Horizontal-Cavity Surface-Emitting Laser-Dioden (HCSELD), vergleiche Appl. Phys. Lett. 84, 4104 (2004); An InGaN-based horizontal-cavity surface-emitting laser diode.

Aus der zum Anmeldezeitpunkt unveröffentlichten Internationalen Patentanmeldung PCT/EP2012/059476 ist die Kontaktierung eines elektrischen Bauteils mit einer elektrisch leitenden Folie, insbesondere einer Trägerfolie durch Niedertemperatursintern von Nanopartikeln offenbart.

Die DE 10 2007 004304 A1 beschreibt einen Dünnfilm-Leuchtdioden-Chip mit einem Schichtenstapel, der eine erste und eine gegenüberliegende zweite Hauptabstrahlfläche aufweist, so dass der Dünnfilm-Leuchtdioden-Chip zumindest zwei Hauptabstrahlrichtungen aufweist. Sowohl auf der ersten als auch auf der zweiten Hauptabstrahlfläche sind Maßnahmen vorgesehen zur Verbesserung der Auskopplung des in der Schichtenfolge erzeugten Lichts.

Der vorliegenden Erfindung liegt demgegenüber die Aufgabe zugrunde, ein verbessertes Verfahren zur Herstellung eines optischen Moduls zu schaffen.

Die der Erfindung zugrunde liegende Aufgabe wird mit den Merkmalen von Patentanspruch 1 gelöst. Ausführungsformen der Erfindung sind in den abhängigen Patentansprüchen angegeben.

Unter einem "optischen Modul" wird hier eine Vorrichtung verstanden, die für Beleuchtungszwecke dient oder als optischer Sender oder Empfänger für die Zwecke der Signalübertragung ausgebildet ist. Das optische Modul kann ein oder mehrere optische Elemente, insbesondere auch eine Matrix optische Elemente beinhalten, wobei es sich bei den optischen Elementen um Strahlungsquellen und/oder optische Empfänger handeln kann.

Unter einem "Chip" wird hier eine integrierte Schaltung verstanden, insbesondere eine integrierte Halbleiterschaltung. In einen solchen Chip kann ein optisches Element integriert sein.

Nach Ausführungsformen der Erfindung erfolgt die Herstellung eines optischen Moduls, indem zunächst ein Chip mit zumindest einem integrierten optischen Element bereitgestellt wird. Das optische Element hat eine erste Elektrode und eine zweite Elektrode und der Chip hat entsprechende erste und zweite Anschlusskontakte für die Elektroden des integrierten optischen Elements. Durch Anlegen einer Betriebsspannung zwischen diesen Anschlusskontakten wird das optische Element aktiviert, um je nach Ausführungsform Strahlung zu emittieren und/oder zu empfangen. Hierzu hat das optische Element eine optisch wirksame Seite, von der aus die Strahlung emittiert wird bzw. über die Strahlung empfangen wird.

Je nach Ausführungsform kann beispielsweise die erste Elektrode transparent oder teiltransparent ausgebildet sein, um die optische wirksame Seite des Chips zu bilden. Es ist aber auch möglich, dass eine Kante des Chips die optisch wirksame Seite des Chips bildet, von der aus die Stahlung abgestrahlt wird, wie es z.B. bei einer EED der Fall sein kann.

Zumindest ein solcher Chip wird dann mit einer Folie verbunden, so dass die Folie zumindest die optisch wirksame Seite des Chips vollständig überdeckt. Die Verbindung des Chips mit der Folie kann beispielsweise durch Kleben, Laminieren und/oder Einpressen erfolgen.

Bei der Folie handelt es sich um Acrylat, Polyarylat oder Polyurethan, wobei die Folie zumindest in dem Bereich, der sich oberhalb der optisch wirksamen Seite befindet, für Strahlung transparent ist, die von dem optischen Element bei anliegender Betriebsspannung emittierbar oder empfangbar ist. Insbesondere kann die Folie insgesamt transparent sein oder transparente Fenster aufweisen. Im letzteren Fall wird ein transparentes Fenster der Folie vor der Verbindung des Chips mit der Folie über der optisch wirksamen Seite des Chips positioniert woraufhin dann die Verbindung z.B. durch laminieren, kleben oder einpressen hergestellt wird.

Nach einer Ausführungsform der Erfindung handelt es sich bei der Folie um eine dünne Epoxid-Folie.

Nach einer Ausführungsform der Erfindung ist auf die Folie eine dünne und flexible Glasfolie laminiert.

Die Kontaktierung zumindest eines der Anschlusskontakte erfolgt dann über die Folie, indem eine auf einer Oberseite oder Rückseite der Folie angeordnete Leiterbahn mit dem Anschlusskontakt elektrisch verbunden wird, wobei die Leiterbahn beispielsweise drucktechnisch auf die Folie aufgebracht sein kann.

Ausführungsformen der Erfindung sind besonders vorteilhaft, da das bisher im Allgemeinen erforderliche Wire-Bonding für die Kontaktierung der Elektroden des optischen Elements aufgrund der Verwendung der Folie entfallen kann. Von besonderem weiterem Vorteil ist dabei, dass die Verbindung des Chips mit der Folie sowie die Kontaktierung der Anschlusskontakte inline erfolgen kann, beispielsweise in einer sogenannten Reel-to-Reel-Fertigung.

Nach einer Ausführungsform der Erfindung erfolgt die Verbindung der Chips mit der Folie durch Einpressen, so dass die Folie die Oberseite des Chips und die Kante des Chips vollflächig überdeckt. Ein solches Einpressen wird aufgrund der plastischen Eigenschaften der verwendeten Folie, nämlich Acrylat, Polyarylat oder Polyurethan, ermöglicht. Besonders bevorzugt ist die Verwendung von kalt verformbaren Arylat, da dann eine wesentliche Erhitzung der Chips für die Verbindung mit der Folie nicht erforderlich ist.

Nach einer Ausführungsform der Erfindung wird nach der Verbindung des Chips mit der Folie ein Loch in der Folie hergestellt, welches sich von der Oberseite der Folie bis zu dem ersten Anschlusskontakt erstreckt. Anschließend erfolgt dann die Kontaktierung des ersten Anschlusskontakts durch das Loch hindurch. Dies kann dadurch erfolgen, dass nach der Herstellung des Lochs durch Aufbringung von leitfähiger Tinte auf die Folie, zum Beispiel durch ein Druckverfahren, wie Inkjet-Druck oder Aerosol-Jet Druck, die Leiterbahn auf die Folie aufgebracht wird sowie auch das Loch mit der leitfähigen Tinte gefüllt wird, um so den Anschlusskontakt durch das Loch hindurch mit der Leiterbahn zu verbinden. Aerosol-Jet Druck ist an sich aus dem Stand der Technik bekannt, vgl. beispielsweise WO 2010/089081 A1.

Nach einer Ausführungsform der Erfindung wird das Loch durch Beaufschlagung der Folie mit einem Laser oder einem Plasma hergestellt, vorzugsweise nachdem der Chip mit der Folie verbunden worden ist, so dass eine nachträgliche genaue Ausrichtung des Lochs bei der Positionierung der Folie bezüglich des Anschlusskontakts nicht erforderlich ist.

Nach einer Ausführungsform der Erfindung beinhaltet die optisch wirksame Seite die erste Elektrode, die zumindest teilweise transparent ausgebildet ist. Die erste Elektrode wird durch sich kreuzende Leiterbahnen gebildet, wobei der erste Anschlusskontakt in einem Randbereich der Oberseite des Chips, insbesondere in einem Randbereich der ersten Elektrode, oder an einer der Kante des Chips angeordnet ist, um möglichst wenig Strahlungseffizienz aufgrund des ersten Anschlusskontakts und dessen Kontaktierung einzubüßen.

Nach einer Ausführungsform der Erfindung erfolgt die Kontaktierung der ersten und je nach Ausführungsform auch der zweiten Anschlusskontakte mit Leiterbahnen der Folie durch Flip-Chip-Montage.

Nach einer Ausführungsform der Erfindung erfolgt die Ausbildung zumindest des ersten Anschlusskontakts durch Niedertemperatursintern von Nanopartikeln, welche auf dem ersten Anschlusskontakt und/oder der Folie aufgebracht sein können. Diese Ausführungsform ist in Kombination mit der Verwendung von kalt verformbarem Acrylat besonders vorteilhaft, da dann insgesamt die Temperaturbeanspruchung der Chips bei der Herstellung minimiert wird.

Nach einer Ausführungsform der Erfindung wird zunächst ein Multilayer Printed Circuit Board (PCB) hergestellt, das eine oder mehrere elektrische und/oder elektronische Komponenten sowie eine Verschaltung dieser Komponenten beinhaltet. Das Multilayer PCB kann bereits einen oder mehrere der Chips mit dem integrierten optischen Element beinhalten. In diesem Fall wird das Multilayer PCB nach oben abgeschlossen, indem die Folie aufgebracht wird. Alternativ wird der Chip zunächst mit der Folie verbunden und kontaktiert und anschließend wird dann die Folie mit dem Chip auf die Multilayer PCB aufgebracht, um diese nach oben abzuschließen. Beispielsweise erfolgt dies, indem die Folie auflaminiert wird.

Nach einer Ausführungsform der Erfindung werden nach diesem Verfahren zwei verschiedene Multilayer PCBs hergestellt, wobei das oder die optischen Elemente in der jeweiligen Multilayer PCB für eine optische Signalübertragung mit galvanischer Trennung zwischen den Multilayer PCBs dienen.

Nach einer Ausführungsform der Erfindung handelt es sich bei der Folie um eine Dekorschicht, was besonders vorteilhaft zur Herstellung eines Beleuchtungskörpers zum Beispiel zur Integration in ein Möbelstück ist.

Nach einer Ausführungsform der Erfindung handelt es sich bei dem optischen Element um eine Solarzelle, die zur photovoltagen Erzeugung von Strom ausgebildet ist. Nach Ausführungsform der Erfindung wird also ein Solarmodul für die Stromerzeugung hergestellt.

Nach einer Ausführungsform der Erfindung handelt es sich bei dem optischen Sensor um einen Sensor für den Empfang von IR oder UV-Strahlung oder andere Strahlung in einem sichtbaren oder nicht sichtbaren Wellenlängenbereich.

Nach einer Ausführungsform der Erfindung ist der optische Sensor für eine drahtlose Energieübertragung ausgebildet, insbesondere für eine Energieübertragung mittels elektromagnetischer Wellen, insbesondere für eine Energieübertragung mittels Laser. Besonders vorzugsweise erfolgt die Energieübertragung mittels elektromagnetischer Wellen, insbesondere in Gigahertz- oder Terrahertzbereich, um einen Energiespeicher, wie zum Beispiel eine aufladbare elektrische Batterie eines elektronischen Geräts, aufzuladen. Bei dem elektronischen Gerät kann es sich zum Beispiel um ein Telekommunikationsgerät, wie zum Beispiel ein Smartphone oder einen Tablet-Computer, oder ein medizintechnisches Gerät insbesondere zur Erfassung eines medizinischen Parameters, wie zum Beispiel ein tragbares Blutdruckmessgerät handeln. Erfindungsgemäß kann die elektrische Batterie des elektronischen Geräts, die zu dessen Energieversorgung dient, mittels der drahtlosen Energieübertragung über den optischen Sensor aufgeladen werden.

Im Weiteren werden Ausführungsformen der Erfindung mit Bezugnahme auf die Zeichnungen näher erläutert. Es zeigen:
- Fig. 1: eine Schnittansicht einer ersten Ausführungsform eines optischen Moduls,
- Fig. 2a - 2d: die Verfahrensschritte einer Ausführungsform eines erfindungsgemäßen Verfahrens zur Herstellung des optischen Moduls gemäß Fig. 1,
- Fig. 3: eine perspektivische Ansicht einer Ausführungsform des optischen Moduls mit Anordnung des ersten Anschlusskontakts in einem Randbereich,
- Fig. 4 - Fig. 9: Schnittansichten verschiedener Ausführungsformen des optischen Moduls als Multilayer PCB,
- Fig. 10: einer Schnittansicht zweier einander gegenüberliegende erfindungsgemäße PCB mit optischer Kopplung.

Elemente der nachfolgenden Ausführungsformen, die einander entsprechen oder identisch sind, werden jeweils mit identischen Bezugszeichen gekennzeichnet.

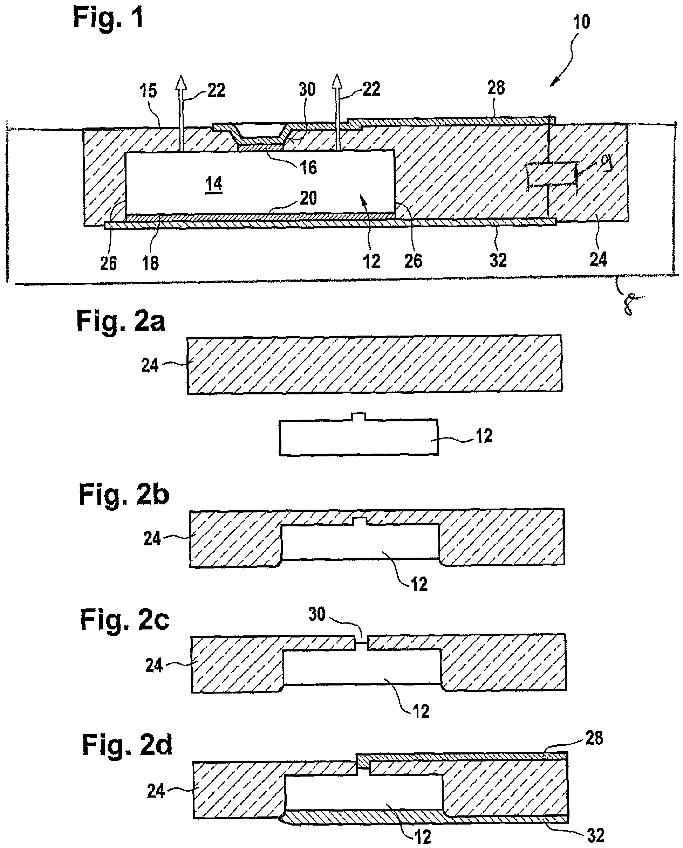

Die Figur 1 zeigt eine Schnittansicht einer Ausführungsform eines optischen Moduls 10, welches einen Chip 12 beinhaltet, der ein in dem Chip integriertes optisches Element 14, wie zum Beispiel einer LED beinhaltet. Das optische Element 14 hat eine erste Elektrode 15, die einen ersten Anschlusskontakt 16 des Chips 12 aufweist, sowie eine zweite Elektrode 18 mit einem zweiten Anschlusskontakt 20 des Chips 12.

Bei der hier betrachteten Ausführungsform ist die erste Elektrode 15 zumindest teilweise transparent ausgebildet, so dass Strahlung nach oben in Pfeilrichtung 22 abgestrahlt werden kann. Der erste Anschlusskontakt 16 befindet sich in etwa mittig auf der ersten Elektrode 15. Dagegen ist die zweite Elektrode 18 flächig und nicht transparent ausgebildet und flächig mit dem zweiten Anschlusskontakt 20 verbunden.

Durch die erste Elektrode 15 wird bei der hier betrachteten Ausführungsform also die optisch wirksame Seite des Chips 12 gebildet.

Der Chip ist mit einer Folie 24 verbunden, wobei die Folie 24 die optisch wirksame Seite des Chips, das heißt hier die erste Elektrode 15, vollständig überdeckt, sowie auch die Kanten 26 des Chips 12.

Bei der Folie handelt es sich um eine Folie aus Acrylat, Polyarylat oder Polyurethan, wobei das Polyurethan ungeschäumt ist. Vorzugsweise wird kalt verformbares Acrylat eingesetzt.

Das Material der Folie ist dabei so gewählt, dass es für Strahlung transparent ist, die von dem optischen Element 14 in der Pfeilrichtung 22 abgegeben wird, wenn eine Betriebsspannung an den Elektroden 15 und 18 anliegt. Dabei kann die Folie insgesamt für diese Strahlung transparent sein oder die Folie kann zumindest oberhalb der ersten Elektrode 15 transparent ausgebildet sein, um dort ein Fenster für den Hindurchtritt der Strahlung zu schaffen.

Die Folie 24 hat auf ihrer Oberseite eine Leiterbahn 28, welche durch ein Loch 30 in der Folie mit dem ersten Anschlusskontakt 16 elektrisch verbunden ist. Auf ihrer Rückseite hat die Folie 22 eine weitere Leiterbahn 32, welche den zweiten Anschlusskontakt 20 kontaktiert.

Beispielsweise ist die Leiterbahn 28 sowie auch die Durchkontaktierung durch das Loch 30 drucktechnisch auf die Oberseite der Folie 24 aufgebracht, wohingegen die Leiterbahn 32 durch eine Strukturierungstechnik, wie zum Beispiel durch Beschichtung der Rückseite mit Kupfer und einem anschließenden Ätzschritt hergestellt wird. Alternativ kann auch die Leiterbahn 32 aufgedruckt sein.

Alternativ oder zusätzlich kann der Chip 12 einen optischen Sensor beinhalten, um ein optisches Signal zum Beispiel zur Auslösung eines Schaltvorgangs zu empfangen oder um elektromagnetische Strahlung für die drahtlose Energieübertragung zu empfangen. Insbesondere kann es sich bei dem Chip 12 um eine Solarzelle für die Erzeugung elektrischer Energie handeln.

Das optische Modul 10 kann einen integralen Bestandteil einer Vorrichtung 8 bilden. Bei der Vorrichtung 8 kann es sich um ein elektronisches Gerät, wie zum Beispiel ein mobiles Telekommunikationsgerät oder ein mobiles batteriebetriebenes medizintechnisches Gerät zur Erfassung eines biologischen Parameters eines Patienten handeln. Beispielsweise hat die Vorrichtung 8 eine wieder aufladbare Batterie 9, die mit dem optischen Modul 10, das heißt dem Chip 12, elektrisch verbunden ist, um diese wieder aufzuladen.

Die Figur 2a bis 2d zeigt die entsprechenden Schritte eines Herstellungsverfahrens. In dem ersten Schritt, der in der Figur 2a dargestellt ist, werden die Folie 24 und der Chip 12 bereitgestellt. Dies kann beispielsweise durch eine Reel-to-Reel-Fertigung erfolgen, indem die Folie 24 von einer Rolle abgewickelt wird und synchron dazu Chips 12, die hintereinander an einem Band befestigt sind, und von denen ein Chip 12 exemplarisch in der Figur 2a gezeigt ist, ebenfalls von einem Band abgewickelt werden.

In dem zweiten Schritt, der in der Figur 2b dargestellt ist, wird der Chip 12 mit der Folie 24 verbunden, indem der Chip 12 in die Folie 24 eingepresst wird, wodurch die Folie 24 plastisch verformt wird. Dies kann beispielsweise dadurch erfolgen, dass die Folie 24 und das Band mit dem Chip 12 an einer Anpressrolle vorbeigeführt werden.

Anschließend wird dann in dem dritten Schritt, der in der Figur 2c dargestellt ist, das Loch 30 in der Folie 24 hergestellt, beispielsweise indem die Folie 20 von oben mit einem Laser oder einem Plasma beaufschlagt wird.

Anschließend werden in dem vierten Schritt, der in der Figur 2d gezeigt ist, die Leiterbahnen 28 und 32 aufgebracht, beispielsweise durch Inkjet-Druck oder durch Aerosol-Jet-Druck, so dass die Anschlusskontakte 16 und 20 (vergleiche Figur 1) hierdurch kontaktiert werden.

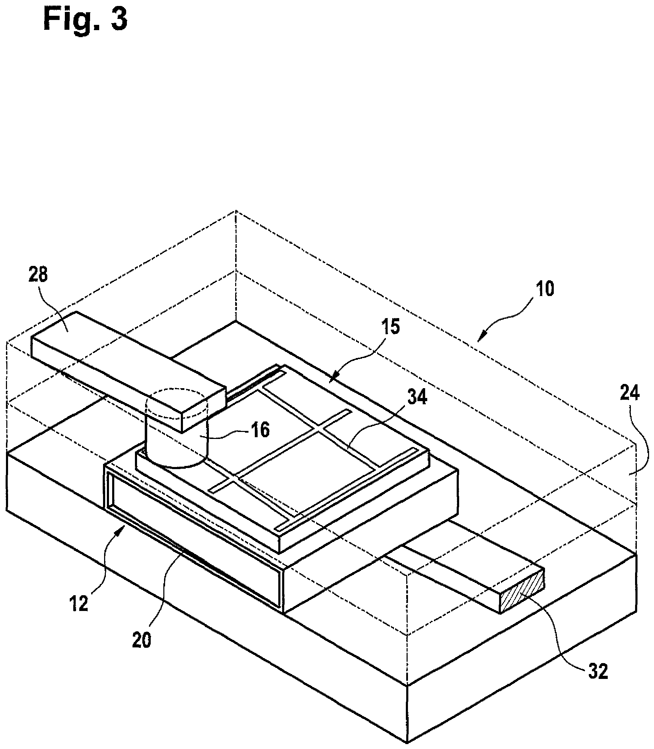

Die Figur 3 zeigt eine perspektivische Darstellung einer Ausführungsform eines optischen Moduls 10, wobei die erste Elektrode 15 durch sich kreuzende Leiterbahnen 34 gebildet wird. Der erste Anschlusskontakt 16 ist hier in einem Randbereich der Elektrode 15 und damit auch des Chips 12 angeordnet, so dass die Leiterbahn 28 von der Elektrode 15 weg verläuft und diese praktisch nicht überdeckt. Dies ist besonders vorteilhaft, da dadurch die Effizienz des optischen Elements 14 gesteigert wird.

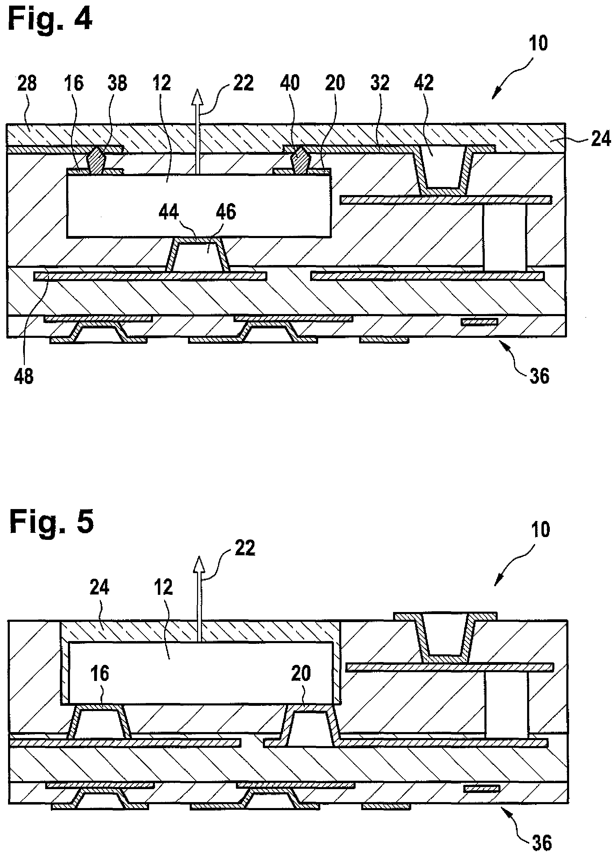

Die Figur 4 zeigt eine Schnittansicht einer Multilayer PCB 36, die den Chip 12 mit dem optischen Element 14 beinhaltet. Im Gegensatz zu den Ausführungsformen gemäß Figuren 1 bis 3 sind hier beide Anschlusskontakte 16 und 20 des optischen Elements 14 an dessen Oberseite, d.h. auf der optisch wirksamen Seite, angeordnet. Diese Anschlusskontakte 16 und 20 sind mit den entsprechenden Leiterbahnen 28 und 32, die bei der hier betrachteten Ausführungsform auf der Unterseite der Folie 24 zum Beispiel drucktechnisch aufgebracht sind durch Flip-Chip-Kontaktierung verbunden, wozu entsprechende Kontaktierhügel 38 bzw. 40, das heißt sogenannte Solder Bumps, vorgesehen sein können.

Die Leiterbahnen 28 und/oder 32 der Folie 24 können zum Beispiel über Vias 42 mit der darunter liegenden Schaltungsstruktur der Multilayer PCB 36 verbunden sein.

Die Herstellung des Moduls 10 kann hier so erfolgen, indem zunächst die Multilayer PCB 36 mit dem Chip 12 und insbesondere dem Via 42 hergestellt wird. Separat davon werden auf die Folie 24 die Leiterbahnen 28 und 32 aufgebracht, beispielsweise drucktechnisch. Schließlich wird die mit den Leiterbahnen 28 und 32 versehene Folie 24 von oben auf die Multilayer PCB 36 aufgebracht, beispielsweise auflaminiert, aufgeklebt oder aufgepresst, so dass die Kontaktierhügel 38 bzw. 40 elektrische Kontakte mit den Leiterbahnen 28 bzw. 32 ausbilden.

Über die Anschlusskontakte 16 und 20 kann eine Betriebsspannung an das optische Element 14 des Chips 12 angelegt werden. Zusätzlich kann der Chip 12 einen Signaleingang 44 aufweisen, der zum Beispiel über ein Via 46 mit einer Leiterbahn 48 des Multilayer PCB 36 elektrisch verbunden ist. Über diese Leiterbahn 48 kann der Chip 12 ein Schaltsignal beispielsweise zum Ein- und Ausschalten des optischen Elements 14 empfangen.

Die Figur 5 zeigt eine weitere Ausführungsform des Multilayer PCB 36, bei der die Anschlusskontakte 16 und 20 an der Unterseite des Chips 12 angeordnet sind und die Folie 24 die Oberseite des Chips 12, welche die optisch wirksame Seite bildet, überdeckt.

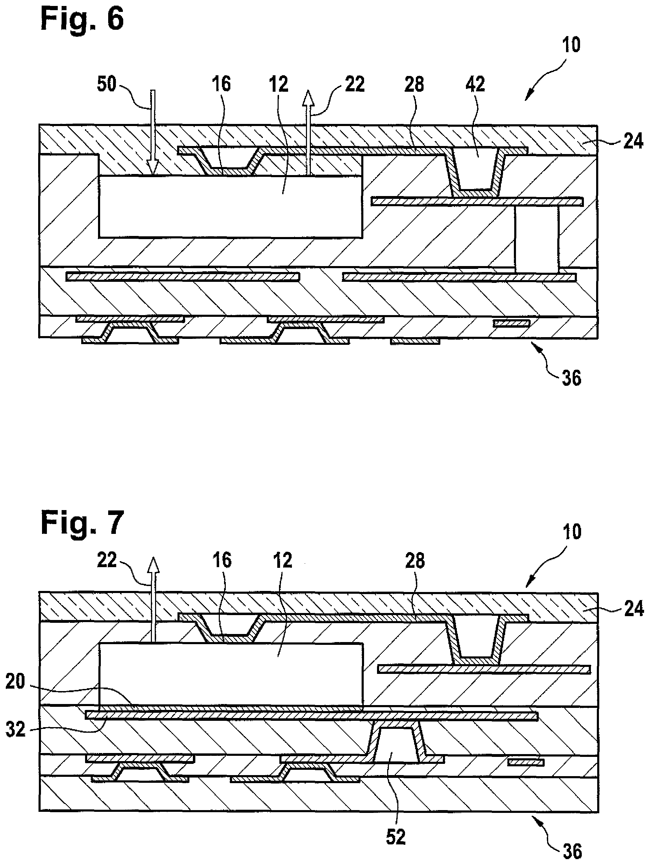

Die Figur 6 zeigt eine weitere Ausführungsform der Multilayer PCB 36. Bei dieser Ausführungsform ist der Anschlusskontakt 16 mittig auf der Oberseite des Chips 12 angeordnet. Die Folie 24 hat an deren Unterseite die Leiterbahn 28, welche mit dem Anschlusskontakt 16 kontaktiert und über das Via 42 mit der Schaltungsstruktur des Multilayer PCB 36. Die Herstellung kann so erfolgen, dass zunächst das Multilayer PCB 36 mit dem Chip 12 hergestellt wird und anschließend die Folie 24 mit der Leiterbahn 28 aufgebracht wird. Der Chip 12 kann hier sowohl zur Abgabe eines optischen Signals in Pfeilrichtung 22 als auch zum Empfang eines optischen Signals in Pfeilrichtung 50 ausgebildet sein.

Nach einer Ausführungsform der Erfindung erfolgt die Ausbildung einer elektrischen Verbindung zwischen dem Anschlusskontakt 16 und der Leiterbahn 28 und/oder zwischen dem Anschlusskontakt 20 und der Leiterbahn 32 durch Niedertemperatursintern.
Hierzu befinden sich beispielsweise auf dem Anschlusskontakt 16 und/oder der Leiterbahn 28 Nanopartikel insbesondere aus Gold, Silber, Nickel oder Kupfer oder aus einer Legierung aus diesen Metallen. Das Niedertemperatursintern zur Verbindung des Anschlusskontakts 16 mit der Leiterbahn 28 kann als "druckloses" Niedertemperatursintern durchgeführt werden, wobei unter "druckfos" hier verstanden wird, dass das Niedertemperatursintern nicht bei den üblicherweise anzuwendenden hohen Drücken von zum Beispiel 200 bar durchgeführt wird, sondern bei einem wesentlich geringeren Druck, wie er auch für das Laminieren verwendet wird, das heißt bei einem Druck von beispielsweise 15-20 bar.

Beispielsweise kann bei der Ausführungsform gemäß Figur 6 so vorgegangen werden, dass die Folie 24 auf die PCB 36 auflaminiert wird und dabei gleichzeitig das drucklose Niedertemperatursintern durchgeführt wird, um den Anschlusskontakt 16 mit der Leiterbahn 28 zu verbinden.

Die Figur 7 zeigt eine der Figur 6 entsprechende Ausführungsform, wobei die Leiterbahn 32 in dem Multilayer PCB 36 und nicht auf der Folie 24 realisiert ist. Die Leiterbahn 32 ist zum Beispiel über ein Via 52 mit weiteren Schaltungsstrukturen des Multilayer PCB verbunden. Diese Ausführungsform ist besonders vorteilhaft, wenn die Folie 24 die Außenseite des optischen Moduls bildet, und beispielsweise ein Dekor aufweist, da das optische Erscheinungsbild dann nicht durch auf der Oberfläche der Folie 24 verlaufende Leiterbahnen beeinträchtigt werden kann.

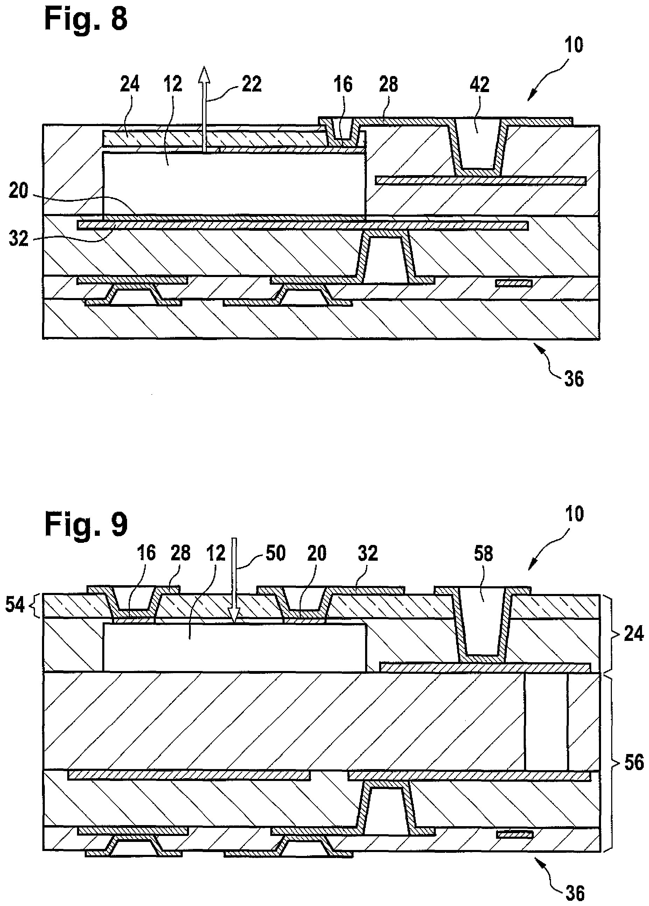

Die Figur 8 zeigt eine weitere Ausführungsform des Multilayer PCB 36, wobei der Anschlusskontakt 16 des Chips 12 hier am Rand der optisch wirksamen Seite des Chips 12 angeordnet ist und die Leiterbahn 28 weg von der optisch wirksamen Seite verläuft, so dass die Leiterbahn 28 keine oder nur eine geringe optisch abdeckende Wirkung auf die optisch wirksame Seite des Chips 12 hat - ähnlich zu der Ausführungsform gemäß Figur 3.

Die Figur 9 zeigt eine weitere Ausführungsform des PCB 36, wobei hier die Folie 24 nur in deren oberen Bereich 54 transparent ist. Die Herstellung kann hier so erfolgen, dass zunächst die Schichten in dem unteren Bereich 56 der Multilayer PCB 36 hergestellt werden. Separat davon wird die Folie 24 mit dem Chip verbunden, beispielsweise durch Einpressen und es werden die Leiterbahnen zur Kontaktierung der Anschlusskontakte 16 und 20 des Chips 12 auf und in der Folie hergestellt, einschließlich des Vias 58, welches hier durch die Folie hindurch verläuft. Die so präparierte Folie mit dem Chip 12 und den Leiterbahnen, insbesondere den Leiterbahnen 28 und 32 zur Kontaktierung des Chips 12, wird dann oben auf den Bereich 56 aufgebracht und mit diesem verbunden, beispielsweise durch Aufkleben, Auflaminieren oder Aufpressen.

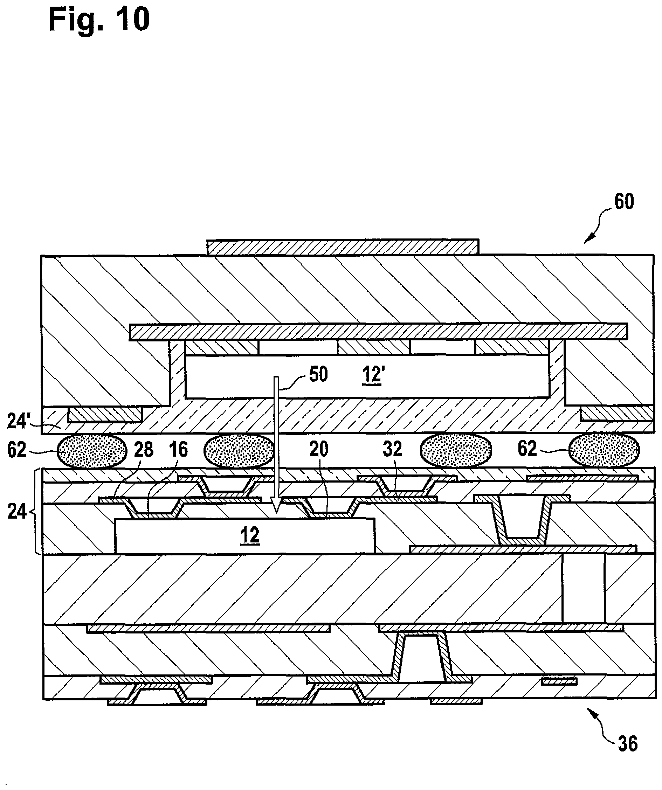

Die Figur 10 zeigt eine weitere Ausführungsform der Multilayer PCB 36 mit einer gegenüberliegenden weiteren Multilayer PCB 60, die ebenfalls nach einer Ausführungsform der Erfindung, insbesondere nach einer der Figuren 4 bis 9 ausgebildet sein kann. Der Chip 12' der Multilayer PCB 60 entspricht dabei dem Chip 12 der Multilayer PCB 36 und ist hier als optischer Sender ausgebildet, wohingegen der Chip 12 als optischer Empfänger ausgebildet ist. Die PCB 36 und 60 sind zum Beispiel durch Löt- oder Klebepunkte 62 miteinander mechanisch, aber nicht galvanisch verbunden, so dass über die Folien 24' und 24 ein optischer Kanal für die optische Signalübertragung von dem PCB 60 an das PCB 36 realisiert ist.

### Bezugszeichenliste

- 8: Vorrichtung
- 9: Batterie
- 10: Optisches Modul
- 12: Chip
- 14: Optisches Element
- 15: erste Elektrode
- 16: erster Anschlusskontakt
- 18: zweite Elektrode
- 20: zweiter Anschlusskontakt
- 22: Pfeilrichtung
- 24: Folie
- 26: Kante
- 28: Leiterbahn
- 30: Loch
- 32: Leiterbahn
- 34: Leiterbahn
- 36: Multilayer PCB
- 38: Kontaktierhügel
- 40: Kontaktierhügel
- 42: Via
- 44: Signaleingang
- 46: Via
- 48: Leiterbahn
- 50: Pfeilrichtung
- 52: Via
- 54: Bereich
- 56: Bereich
- 58: Via
- 60: PCB

## Patentansprüche

1. Verfahren zur Herstellung eines optischen Moduls (10) mit den folgenden Schritten:
a) Bereitstellen eines Chips (12) mit einem in den Chip integrierten optischen Element (14), wobei das optische Element eine erste Elektrode (15) und eine zweite Elektrode (18) aufweist, und wobei der Chip einen ersten Anschlusskontakt (16) für die erste Elektrode und einen zweiten Anschlusskontakt (20) für die zweite Elektrode aufweist, so dass zwischen den ersten und zweiten Anschlusskontakten eine Betriebsspannung für das optische Element anlegbar ist, und wobei der Chip eine optisch wirksame Seite (15) hat, welche dazu ausgebildet ist Strahlung zu emittieren und/oder zu empfangen,
b) Verbindung des Chips mit einer Folie (24), so dass die Folie die optisch wirksame Seite des Chips vollflächig überdeckt, wobei es sich bei der Folie um eine Folie aus Acrylat, Polyarylat oder Polyurethan handelt, wobei die Folie zumindest in dem Bereich, der sich oberhalb der optisch wirksame Seite befindet, für Strahlung transparent ist, die von dem optischen Element bei anliegender Betriebsspannung emittierbar oder empfangbar ist,
c) Kontaktierung des ersten Anschlusskontakts des Chips durch eine auf der Folie angeordnete Leiterbahn (28) und Kontaktierung des zweiten Anschlusskontakts durch eine weitere Leiterbahn (32),
wobei die Verbindung des Chips mit der Folie durch Einpressen des Chips in die Folie erfolgt, so dass die Folie die Oberseite des Chips und die Kanten des Chips vollflächig überdeckt.

2. Verfahren nach Anspruch 1, wobei es sich bei der Folie um ein kalt verformbares Acrylat handelt.

3. Verfahren nach einem der vorhergehenden Ansprüche, wobei sich die optisch wirksame Seite auf der Oberseite des Chips befindet, und sich der erste Anschlusskontakt auf der Oberseite des Chips befindet, wobei nach der Verbindung des Chips mit der Folie ein Loch (30) in der Folie hergestellt wird, welches sich von der Oberseite der Folie bis zu dem ersten Anschlusskontakt erstreckt, und wobei anschließend die Kontaktierung des ersten Anschlusskontakts des Chips mit der auf der Folie angeordneten Leiterbahn (28)durch das Loch hindurch erfolgt.

4. Verfahren nach Anspruch 3, wobei das Loch durch Beaufschlagung der Folie mit einem Laser oder einem Plasma hergestellt wird, und/oder wobei die Aufbringung der Leiterbahn auf die Folie und die Kontaktierung der Leiterbahn durch das Loch drucktechnisch erfolgt, und/oder die weitere Leiterbahn (32) drucktechnisch aufgebracht wird, beispielsweise durch Inkjet-Druck oder Aerosol-Jet-Druck.

5. Verfahren nach Anspruch 3 oder 4, wobei das Loch durch Beaufschlagung der Folie mit einem Laser oder einem Plasma hergestellt wird.

6. Verfahren nach einem der vorhergehenden Ansprüche, wobei die optisch wirksame Seite die erste Elektrode beinhaltet, wobei die erste Elektrode des optischen Elements durch sich kreuzende Leiterbahnen (34) gebildet wird und der erste Anschlusskontakt mit zumindest einer der sich kreuzenden Leiterbahnen verbunden ist, wobei der erste Anschlusskontakt in einem Randbereich der Oberseite des Chips oder an einer der Kanten (26) des Chips angeordnet ist.

7. Verfahren nach einem der vorhergehenden Ansprüche, wobei es sich bei dem optischen Element um eine photovoltaische Solarzelle handelt.

8. Verfahren nach einem der vorhergehenden Ansprüche, wobei das optische Element eine oder mehrere Leuchtdioden (LED), edge-emitting laser Dioden (EED), horizontal-cavity surface-emitting laser Dioden (HCSELD), organische Leuchtdioden (OLED) oder Polymer-Leuchtdioden (PLED) und/oder einen optischen Sensor beinhaltet.

9. Verfahren nach Anspruch 8, wobei es sich bei dem optischen Sensor um einen Sensor für den Empfang mit Strahlung in einem sichtbaren oder unsichtbaren Wellenlängenbereich handelt.

10. Verfahren nach einem der Ansprüche 8 oder 9, wobei der optische Sensor zum Empfang von Strahlung für eine drahtlose Energieübertragung ausgebildet ist, und wobei der Sensor mit einem Energiespeicher zum Speicherung der von dem Sensor empfangenen Energie elektrisch verbunden wird.

11. Verfahren nach Anspruch 10, wobei es sich bei dem Energiespeicher um eine aufladbare elektrische Batterie (9) handelt, wobei der Sensor dazu ausgebildet ist, die empfangene Energie in elektrische Energie umzuwandeln, um mit der elektrischen Energie die Batterie aufzuladen.

12. Verfahren nach einem der vorhergehenden Ansprüche, wobei zumindest einer der ersten Anschlusskontakte einen Kontaktierhügel (38, 40) für eine Flip-Chip-Montage aufweist, um den zumindest einen ersten Anschlusskontakt mittels Flip-Chip-Montage mit der auf der Folie angeordneten Leiterbahn (28, 32) zu kontaktieren.

13. Verfahren nach einem der vorhergehenden Ansprüche, wobei Nanopartikel verwendet werden, um die Kontaktierung zumindest des ersten Anschlusskontakts mit der auf der Folie angeordneten Leiterbahn durch Niedertemperatursintern der Nanopartikel herzustellen, wobei die Nanopartikel auf dem ersten Anschlusskontakt und/oder der Folie aufgebracht sind.

14. Verfahren nach Anspruch 13, wobei das Niedertemperatursintern als druckloses Niedertemperatursintern durchgeführt wird und die Verbindung des Chips mit der Folie durch Auflaminieren erfolgt, wobei das Auflaminieren gleichzeitig mit dem drucklosen Niedertemperatursintern durchgeführt wird.

15. Verfahren nach Anspruch 14, wobei der Druck bei dem drucklosen Niedertemperatursintern zwischen 15 bar und 20 bar beträgt.

16. Verfahren nach einem der vorhergehenden Patentansprüche, wobei die Folie mit dem Chip nach unten auf eine Multilayer PCB (36) aufgebracht wird, so dass die auf der Folie angeordnete Leiterbahn mit einer Leiterbahn der Multilayer PCB eine Verbindung ausbildet.

17. Verfahren nach Anspruch 16, wobei die Folie auflaminiert wird.

18. Verfahren nach Anspruch 16 oder 17, wobei eine weitere Multilayer PCB (60), die nach einem Verfahren gemäß Patentanspruch 10 oder 11 hergestellt worden ist, mit der Multilayer PCB verbunden wird, so dass eine optische Signalübertragung zwischen dem optischen Element der Multilayer PCB und der weiteren Multilayer PCB erfolgen kann.

19. Verfahren nach einem der vorhergehenden Ansprüche, wobei es sich bei dem optischen Modul um eine Beleuchtungseinheit, einen optischen Sender und/oder einen optischen Empfänger handelt.

20. Verfahren nach einem der vorhergehenden Ansprüche, wobei die ersten und zweiten Anschlusskontakte auf der Oberseite des Chips angeordnet sind.

21. Verfahren nach einem der vorhergehenden Ansprüche, wobei es sich bei der Folie um eine Epoxid-Folie handelt.

22. Verfahren nach einem der vorhergehenden Ansprüche, wobei auf die Folie eine flexible Glasfolie laminiert ist.

23. Verfahren nach einem der vorhergehenden Ansprüche, wobei die Herstellung des optischen Moduls in einer Reel-to-Reel-Fertigung erfolgt.

24. Verfahren nach Anspruch 23, wobei der Chip (12) auf einem Band bereitgestellt wird, wobei das Band weitere der Chips (12) trägt, die hintereinander an dem Band befestigt sind, und die Folie (24) auf einer Rolle bereitgestellt wird, wobei die Reel-to-Reel Fertigung so erfolgt, dass die Folie von der Rolle abgewickelt wird und synchron dazu die Chips ebenfalls von deren Band abgewickelt werden, so dass der Chip (12) mit der Folie verbunden wird, indem der Chip in die Folie eingepresst wird, wodurch die Folie plastisch verformt wird, indem die Folie und das Band mit dem Chip (12) an einer Anpressrolle vorbeigeführt werden.

## Claims

1. A method for producing an optical module (10), comprising the following steps:
a) providing a chip (12) having an optical element (14) integrated therein, wherein the optical element includes a first electrode (15) and a second electrode (18), the chip has a first connecting contact (16) for the first electrode and a second connecting contact (20) for the second electrode, so that an operating voltage for the optical element can be applied between the first and second connecting contacts, and the chip has an optically active side (15) designed to emit and/or receive radiation;
b) joining the chip to a film (24), so that the film covers the entire surface area of the optically active side of the chip, wherein the film is a film made of acrylate, polyarylate or polyurethane, and the film is transparent to radiation, which can be emitted or received by the optical element when operating voltage is applied, at least in the region located above the optically active side; and
c) contacting the first connecting contact of the chip by a conductor track (28) arranged on the film, and contacting the second connecting contact by a further conductor track (32),
wherein joining the chip to the film takes place by pressing the chip into the film so that the film covers the entire surface area of the top side of the chip and the edges of the chip.

2. The method according to claim 1, wherein the film is a cold-deformable acrylate.

3. The method according to any one of the preceding claims, wherein the optically active side is situated on the top side of the chip, and the first connecting contact is situated on top of the chip, a hole (30) extending from the top side of the film to the first connecting contact is created in the film after the chip has been joined to the film, and subsequently the contacting of the first connecting contact of the chip with the conductor track (28) arranged on the film takes place through the hole.

4. The method according to claim 3, wherein the hole is created by a laser or a plasma acting on the film, and/or wherein the application of the conductor track onto the film and the contacting of the conductor track through the hole take place by way of printing, and/or the further conductor track (32) is applied by way of printing, for example by way of ink jet printing or aerosol jet printing

5. The method according to claim 3 or 4, wherein the hole is created by a laser or a plasma acting on the film.

6. The method according to any one of the preceding claims, wherein the optically active side includes the first electrode, the first electrode of the optical element is formed by intersecting conductor tracks (34), and the first connecting contact is connected to at least one of the intersecting conductive tracks, the first connecting contact of the chip being arranged in an edge region of the top side of the chip or on one of the edges (26) of the chip.

7. The method according to according to any one of the preceding claims, wherein the optical element is a photovoltaic solar cell.

8. The method according to any one of the preceding claims, wherein the optical element comprises one or more light emitting diodes (LED), edge-emitting laser diodes (EED), horizontal-cavity surface-emitting laser diodes (HCSELD), organic light emitting diodes (OLED) or polymer light emitting diodes (PLED), and/or an optical sensor

9. The method according to claim 8, wherein the optical sensor is a sensor for receiving radiation in a visible or invisible wavelength range.

10. The method according to either claim 8 or 9, wherein the optical sensor is designed to receive radiation for wireless energy transmission, and the sensor is electrically connected to an energy storage device for storing the energy received from the sensor.

11. The method according to claim 10, wherein the energy storage device is a rechargeable electric battery (9), and the sensor is designed to convert the received energy into electrical energy so as to charge the battery with the electrical energy.

12. The method according to any one of the preceding claims, wherein at least one of the first connecting contacts comprises a solder bump (38, 40) for flip chip mounting so as to contact the at least one first connecting contact with the conductor track (28, 32) arranged on the film by way of flip chip mounting.

13. The method according to any one of the preceding claims, wherein nanoparticles are used to establish the contacts between at least the first connecting contact and the conductor track arranged on the film by way of low-temperature sintering of the nanoparticles, the nanoparticles being applied to the first connecting contact and/or the film.

14. The method according to claim 13, wherein the low-temperature sintering is carried out as pressure-free low-temperature sintering, and the joining of the chip to the film is carried out by way of lamination, the lamination being carried out simultaneously with the pressure-free low-temperature sintering.

15. The method according to claim 14, wherein the pressure during the pressure-free low-temperature sintering is between 15 bar and 20 bar.

16. The method according to any one of the preceding claims, wherein the film, together with the chip, is applied face down onto a multilayer PCB (36) so that the conductor track arranged on the film forms a connection with a conductor track of the multilayer PCB.

17. The method according to claim 16, wherein the film is laminated on.

18. The method according to claim 16 to 17, wherein a further multilayer PCB (60), which was produced by a method according to claim 10 or 11, is connected to the multilayer PCB, so that optical signal transmission can take place between the optical element of the multilayer PCB and the further multilayer PCB.

19. The method according to any one of the preceding claims, wherein the optical module is a lighting unit, an optical transmitter and/or an optical receiver.

20. The method according to according to any one of the preceding claims,
wherein the first and second connecting contacts are arranged on the top side of the chip.

21. The method according to according to any one of the preceding claims,
wherein the film is an epoxy film.

22. The method according to any one of the preceding claims, wherein a flexible glass film is laminated onto the film.

23. The method according to according to any one of the preceding claims,
wherein the production of the optical module takes place in a reel-to-reel production.

24. The method according to claim 23, wherein the chip (12) is provided on a tape, the tape carrying further chips (12) consecutively secured to the tape, and the film (24) is provided on a roll, the reel-to-reel production taking place in such a way that the film is unwound from the roll and synchronously therewith the chips are likewise unwound from the tape, so that the chip (12) is joined to the film by pressing the chip into the film, whereby the film is plastically deformed by guiding the film and the tape with the chip (12) past a pressing roller.

## Revendications

1. Procédé de fabrication d'un module optique (10) avec les étapes suivantes :
a) mise au point d'une puce (12) avec un élément optique (14) intégré dans la puce, où l'élément optique présente une première électrode (15) et une deuxième électrode (18), et où la puce présente une première borne de contact (16) pour la première électrode et une deuxième borne de contact (20) pour la deuxième électrode, de sorte qu'une tension de fonctionnement pour l'élément optique peut être appliquée entre la première et la deuxième borne de contact, et où la puce a une face active optiquement (15), laquelle est conçue pour émettre et/ou recevoir un rayonnement,
b) mise en communication de la puce avec un film (24), de sorte que le film recouvre toute la surface de la face active optiquement de la puce, où, dans le cas du film, il s'agit d'un film constitué d'acrylate, de polyarylate ou de polyuréthane, où le film est transparent au rayonnement au moins dans la région qui se trouve au dessus de la face active optiquement, qui peut être émis ou reçu de l'élément optique lors de l'application de la tension de fonctionnement,
c) mise en contact de la première borne de contact de la puce par une piste conductrice (28) disposée sur le film et mise en contact de la deuxième borne de contact par une autre piste conductrice (32),
où la mise en communication de la puce avec le film est effectuée par une incorporation sous pression de la puce dans le film de sorte que le film recouvre totalement la surface de la face supérieure de la puce et des arêtes de la puce.

2. Procédé selon la revendication 1, dans lequel il s'agit d'un acrylate déformable à froid dans le cas du film.

3. Procédé selon l'une des revendications précédentes, dans lequel la face active optiquement se situe sur la face supérieure de la puce, et la première borne de contact se situe sur la face supérieure de la puce, où, après la mise en communication de la puce avec le film, un trou (30) est formé dans le film, lequel s'étend à partir de la face supérieure du film jusqu'à la première borne de contact, et où, ensuite, la mise en contact de la première borne de contact de la puce avec la piste conductrice (28) disposée sur le film est effectuée par la traversée du trou.

4. Procédé selon la revendication 3, dans lequel le trou est fabriqué par la soumission du film à un laser ou à un plasma, et/ou où la mise en place de la piste conductrice sur le film et la mise en contact de la piste conductrice sont effectuées de manière typographique par le trou, et/ou l'autre piste conductrice (32) est rapportée de manière typographique, par exemple, par une impression à jet d'encre ou une impression à jet d'aérosol.

5. Procédé selon la revendication 3 ou 4, dans lequel le trou est fabriqué par la soumission du film à un laser ou à un plasma.

6. Procédé selon l'une des revendications précédentes, dans lequel la face active optiquement contient la première électrode, où la première électrode de l'élément optique est formée par des pistes conductrices (34) se croisant et la première borne de contact est reliée avec au moins l'une des pistes conductrices se croisant, où la première borne de contact est disposée sur une région de bordure de la face supérieure de la puce ou sur l'une des arêtes (26) de la puce.

7. Procédé selon l'une des revendications précédentes, dans lequel il s'agit d'une cellule solaire photovoltaïque dans le cas de l'élément optique.

8. Procédé selon l'une des revendications précédentes, dans lequel l'élément optique contient une ou plusieurs diodes luminescentes (DEL), diodes laser à émission périphérique (EED), diodes laser à cavité horizontale émettent par la surface (HCSELD), diodes lumineuses organiques (OLED) ou diodes lumineuses à polymère (PLED) et/ou un capteur optique.

9. Procédé selon la revendication 8, dans lequel, dans le cas du capteur optique, il s'agit d'un capteur prévu pour la réception avec un rayonnement dans le domaine de longueur d'onde visible ou non visible.

10. Procédé selon l'une des revendications 8 ou 9, dans lequel le capteur optique pour la réception du rayonnement est conçu pour une transmission d'énergie sans fil, et où le capteur est relié électriquement avec un accumulateur d'énergie pour l'alimentation de l'énergie reçue par le capteur.

11. Procédé selon la revendication 10, dans lequel, dans le cas de l'accumulateur d'énergie, il s'agit d'une batterie (9) électrique pouvant être chargée, où le capteur est conçu pour transformer l'énergie reçue en énergie électrique, afin de charger la batterie avec l'énergie électrique.

12. Procédé selon l'une des revendications précédentes, dans lequel au moins l'une des premières bornes de contact présente une bosse de contact (38, 40) pour un montage de puce retournée, afin de mettre en contact au moins une première borne de contact au moyen d'un montage de puce retournée avec la piste conductrice (28, 32) disposée sur le film.

13. Procédé selon l'une des revendications précédentes, dans lequel on emploie des nanoparticules afin de réaliser la mise en contact d'au moins la première borne de contact avec la piste conductrice disposée sur le film par un frittage à basse température des nanoparticules, où les nanoparticules sont rapportées sur la première borne de contact et/ou sur le film.

14. Procédé selon la revendication 13, dans lequel le frittage à basse température est effectué comme un frittage à basse température sans pression et la mise en communication de la puce avec le film est effectuée par un dépôt par laminage, où le dépôt par laminage est effectué simultanément avec le frittage à basse température sans pression.

15. Procédé selon la revendication 14, dans lequel la pression lors du frittage à basse température sans pression se situe entre 15 bar et 20 bar.

16. Procédé selon l'une des revendications précédentes, dans lequel le film avec la puce est rapporté par le bas sur un circuit imprimé multicouche Multilayer PCB (36) de sorte que la piste conductrice disposée sur le film forme une liaison avec la piste conductrice du circuit imprimé multicouche.

17. Procédé selon la revendication 16 dans lequel le film est plaqué par laminage.

18. Procédé selon la revendication 16 ou 17, dans lequel un autre circuit imprimé multicouche Multilayer PCB (60), qui a été fabriqué selon un procédé selon la revendication 10 ou 11, est relié avec le circuit imprimé multicouche, de sorte qu'une transmission de signal optique peut avoir lieu entre l'élément optique du circuit imprimé multicouche et celui de l'autre circuit imprimé multicouche.

19. Procédé selon l'une des revendications précédentes, dans lequel, dans le cas du module optique, il s'agit d'une unité d'éclairage, d'un émetteur optique et/ou d'un récepteur optique.

20. Procédé selon l'une des revendications précédentes, dans lequel les premières et deuxièmes bornes de contact sont disposées sur la face supérieure de la puce.

21. Procédé selon l'une des revendications précédentes, dans lequel il s'agit d'un film en époxyde dans le cas du film.

22. Procédé selon l'une des revendications précédentes, dans lequel un film de verre souple est déposé par laminage sur le film.

23. Procédé selon l'une des revendications précédentes, dans lequel la fabrication du module optique a lieu dans une finition bande à bande.

24. Procédé selon la revendication 23, dans lequel la puce (12) est mise en place sur une bande, où la bande porte d'autres puces qui sont fixées les unes derrière les autres sur la bande, et le film (24) est mis en place sur un rouleau, où la finition bande à bande a lieu de telle manière que le film est déroulé du rouleau et que les puces sont également déroulées de leur bande de manière synchronisée de sorte que la puce (12) est reliée avec le film, la puce est ainsi incorporée par pression dans le film, ce par quoi le film est déformé de manière plastique, ainsi, le film et la bande avec la puce (12) sont passés devant un rouleau d'application par pression.
